# EUROPÄISCHE PATENTSCHRIFT

(11) **EP 0 352 860 B1**
(45) Veröffentlichungstag und Bekanntmachung des Hinweises auf die Patenterteilung: **06.10.1993**
(21) Anmeldenummer: 89201933.2
(22) Anmeldetag: 24.07.1989
(51) Int. Cl.: C30B 25/06, C30B 29/28, C23C 14/08

(54) **Verfahren zur Herstellung von Eisengranatschichten**
Process for producing iron garnet coatings
Procédé de production de couches de grenat de fer

(30) Priorität: 29.07.1988 DE 3825787
(43) Veröffentlichungstag der Anmeldung: 31.01.1990
(73) Patentinhaber: Philips Patentverwaltung GmbH, 22335 Hamburg (DE); Philips Electronics N.V., 5621 BA Eindhoven (NL)
(72) Erfinder: Petruzzello, John, Briarcliff Manor, N.Y. 10510 (US); Krumme, Jens-Peter, Dr., D-2000 Hamburg 55 (DE); Radtke, Wolfgang, D-2409 Scharbeutz 2 (DE)
(74) Vertreter: Kupfermann, Fritz-Joachim, Dipl.-Ing.

(56) Entgegenhaltungen:
- EP-A- 0 239 140
- EP-A- 0 252 536
- JOURNAL OF APPLIED PHYSICS, Band 57, Nr. 8, Teil 2B, 15 April 1985; M.GOMI et al.: "rf Sputtering of highly Bi-substituted garnet films on glass substrates for magneto-optic memory" Seiten 3888-3890

## Beschreibung

Die Erfindung betrifft ein Verfahren zur Herstellung von Eisengranatschichten in einer Schichtenfolge unterschiedlicher Ordnung mittels HF-Kathodenzerstäubung unter Verwendung eines überwiegend eine Eisengranatphase neben Restphasen nahezu gleicher Zerstäubungsrate enthaltenden Targets in einem Edelgasplasma einer Ionenenergie der die anwachsende Schicht bombardierenden Ionen kleiner als 10² eV und eines Drucks im Bereich von 0,1 bis 2,0 Pa auf einem Substrat.

Ein derartiges Verfahren ist aus der europäischen Patentanmeldung mit der Veröffentlichungsnummer 0 252 536 A1 bekannt. Schichten, die nach dem bekannten Verfahren hergestellt werden, werden zum Aufbau von optischen Wellenleitern für nicht-reziproke optische Bauelemente eingesetzt. Um bei der reversiblen magneto-optischen Datenspeicherung in Eisengranat- oder Ortho- oder Hexaferritschichten ein nur geringes Rauschen im Auslesesignal zu erzielen oder um bei optischen Wellenleitern die Streuverluste klein zu halten, sind morphologisch "glatte" Schichten von besonderem Vorteil.

Werden z.B. polykristalline Schichten aus Eisengranat auf Substraten abweichender Ordnung abgeschieden, ergeben sich Schichten, die eine gewisse Oberflächenrauhigkeit aufweisen, die also morphologisch nicht "glatt" sind. Wird beispielsweise mittels HF-Kathodenzerstäubung in einem Argon-Plasma eines Drucks von 0,6 Pa bei Temperaturen größer als 520 °C Eisengranat polykristallin auf Glassubstraten abgeschieden, ergibt sich eine Folge von groben, feinen und schließlich säulenförmigen Kristalliten statistischer Kristallausrichtung, was zu Schichten mit relativ großer Oberflächenrauhigkeit führt.

Die mit dieser Morphologie einhergehende gezackte magnetische Domänenstruktur hoher Koerzitivfeldstärke und relativ hohe Lichtstreuungsverluste weisen auf eine ausgesprägte Kornstruktur hin.

Der Erfindung liegt die Aufgabe zugrunde, ein Verfahren anzugeben, mit dem polykristalline Eisengranatschichten einer Morphologie, die der von einkristallinen Eisengranatschichten nahekommt und die eine ausgeprägte Textur aufweisen, hergestellt werden können.

Diese Aufgabe wird erfindungsgemäß dadurch gelöst, daß unter Einspeisung von HF-Leistung mit einer HF-Spannung von etwa 200 V_{eff} in die Targetelektrode (Kathode) bei einer Substrattemperatur kleiner als 460 ^{o}C zunächst eine amorphe bis röntgenamorphe Eisengranatschicht als Zwischenschicht und danach bei einer Substrattemperatur größer als 520 ^{o}C eine polykristalline Eisengranatschicht abgeschieden wird unter gleichzeitigem Anlegen einer HF-Spannung an die Substratelektrode von etwa 50 V_{eff}, die linear während der Abscheidung der ersten 5 bis 10 nm Schichtdicke auf ein gegenüber Masse schwebendes Potential zurückgeführt wird.

Der Erfindung liegt die Erkenntnis zugrunde, daß die inhomogene Kristallitstruktur, die infolge der Kristallitkeimbildung im Grenzbereich zwischen Substrat und anwachsender Schicht und infolge des weiteren Kristallwachstums in der anwachsenden Schicht entsteht, durch Teilchenbeschuß mit niederenergetischen Ionen beeinflußt werden kann. Dadurch können die Zahl der Kristallitkeime pro Flächeneinheit erhöht und deren kristallographische Orientierung an der Grenzfläche zum Substrat vereinheitlicht werden.

Der HF-Potentialabfall an der Substratelektrode kann dadurch eingestellt werden, daß entweder die Substratelektrode über eine verstellbare HF-Impedanz gegen Masse gelegt wird oder daß HF-Leistung aus dem HF-Sender in die Substratelektrode gleichzeitig mit der HF-Leistung in die Targetelektrode eingespeist wird. Dadurch wird am Substrat ein von etwa 50 V bis schwebend einstellbares HF-Potential aufgebaut, was Ionenbeschuß der anwachsenden Schicht mit einstellbaren Energien unter 100 eV zur Folge hat.

Nach vorteilhaften Ausgestaltungen des Verfahrens nach der Erfindung werden Eisengranatschichten einer Zusammensetzung gemäß der allgemeinen Formel (A,B)₃(A,B)₅O₁₂ mit A = mindestens ein Seltenerdmetall, Bi,Pb und/oder Ca und B = Ga, Al, Fe, Co, Ni, Mn, Ru, Ir, In und/oder Sc hergestellt.

Es wurde z.B. eine polykristalline Eisengranatschicht mit folgender Zusammensetzung hergestellt:
Gd₂,₁₁Bi₁,₀₁Fe₄,₀₆Ga₀,₈₂O₁₂. Eine amorphe Eisengranatschicht wurde z.B. mit folgender Zusammensetzung hergestellt:
Gd₂,₁₈Bi₀,₃₆Fe₄,₃₁Ga₁,₁₅O₁₂.

Nach weiteren vorteilhaften Ausgestaltungen des Verfahrens gemäß der Erfindung werden Substrate einkristalliner Ordnung, z.B. aus Halbleitermaterial wie z.B. III-V-Verbindungen oder Silicium, oder es werden Substrate nicht-einkristalliner Ordnung, z.B. aus Glas und insbesondere Quarzglas oder aus thermisch oxidiertem Silicium, eingesetzt.

Werden z.B. auf einkristallinen Substraten aus Halbleitermaterial, wie z.B. III-V-Verbindungen wie Galliumarsenid oder Indiumphosphid, amorphe und/oder polykristalline Eisengranatschichten abgeschieden, ist es beispielsweise möglich, integrierte optoelektronische Bauelemente mit gyrotropen Eigenschaften auf Granatbasis zu realisieren. Zu denken ist hier an die Kombination von Laserdioden mit optischen Isolatoren.

Mit dem vorliegenden Verfahren ist der Vorteil verbunden, daß auf nahezu beliebigen Substraten eine Morphologie von polykristallinen Eisengranatschichten erzielt werden kann, die der von einkristallinen Eisengranatschichten nahekommt.

Nach einer vorteilhaften Weiterbildung des Verfahrens gemäß der Erfindung wird als Targetelektrode ein Magnetron, in das die für den Zerstäubungsprozeß erforderliche HF-Leistung eingespeist wird, eingesetzt. Ein Magnetron bewirkt, daß das Plasma in Targetnähe konzentriert und somit der Ionenbeschuß der wachsenden Schicht drastisch vermindert wird, so daß z.B. das Wachstum der kristallinen Schicht beeinträchtigende Rückstäubungseffekte minimiert werden. Bei Verwendung einer Magnetronelektrode ist es zweckmäßig, für das zu zerstäubende Target eine Phasenzusammensetzung zu wählen, die eine möglichst kleine Sättigungsmagnetisierung aufweist, um eine weitestgehende Konzentrierung des Plasmas in Targetnähe zu bewirken. Mit der Anwendung eines Magnetrons ist darüberhinaus der Vorteil verbunden, daß der Abstand zwischen Target und Substrat im Vergleich zu Verfahren, die mit HF-Kathodenzerstäubungsanlagen in Diodenanordnung arbeiten, optimiert werden kann im Sinne einer möglichst geringen Plasmadichte und kinetischen Energie in der Nähe des Substrats bei einer möglichst hohen Abscheidungsrate.

Für die HF-Kathodenzerstäubung können im Handel erhältliche, mit HF-Spannung zu betreibende Kathodenzerstäubungsanlagen mit einer mit Magnetsystem ausgestatteten Targetkathode (Magnetron) benutzt werden, wobei eine Vorrichtung zur Messung der effektiven HF-Spannung sowohl an der Targetelektrode als auch an der Substratelektrode vorzusehen ist. Die Magnetronkathode ist liegend in einen herkömmlichen Vakuumrezipienten eingebaut. Die Konstanthaltung der HF-Spannung an der Targetelektrode auf Werte besser als ± 1 % wird über eine Rechnersteuerung erreicht. Ebenfalls werden der Druck und die Zusammensetzung des Prozeßgases durch Rechnersteuerung auf besser als ± 1 % konstant gehalten. Als Energiequelle für die Zerstäubungseinrichtung dient ein normaler HF-Generator, der bei einer Ausgangsleistung von 200 W betrieben wird. Die Betriebsfrequenz liegt bei 13,56 MHz.

Die vor Beginn der Abscheidung der polykristallinen Eisengranatschicht an der Substratelektrode einzustellende HF-Spannung von etwa 50 V_{eff} wird entweder gleichzeitig mit der HF-Spannung an der Targetelektrode aus dem HF-Generator über ein Impedanzanpassungsglied eingespeist oder sie wird durch Verbinden der Substratelektrode über das oben genannte Impedanzanpassungsglied mit Masse eingestellt. Die an die Substratelektrode angelegte HF-Spannung wird während der Abscheidung der ersten 5 bis 10 nm Schichtdicke durch Verstellen des Impedanzanpassungsgliedes auf ein gegenüber Masse schwebendes Potential zurückgeführt. Damit wird die Energie der auf die anwachsende Schicht auftreffenden Edelgasionen soweit vermindert, daß Rückstäubungseffekte der anwachsenden Schicht vernachlässigbar gering werden und das weitere Schichtwachstum ungestört ablaufen kann.

Anhand eines Ausführungsbeispieles wird die Erfindung beschrieben und in ihrer Wirkungsweise erläutert.

Als Targets (kathodische Zerstäubungsquelle) wurden durch Heißpressen oder Sintern aus Eisengranat-Mischoxiden hergestellte Körper eines Durchmessers von 75 mm, einer Dicke von 4 mm und einer Porosität kleiner als 10 % und vorzugsweise einer magnetischen Sättigungspolarisation I_{S} < 3 mT eingesetzt.

Als Substrate wurden (111)-orientierte Calcium-Magnesium-Zirkonium-substituierte Gadolinium-Gallium-Granat-Einkristallscheiben der allgemeinen Formel
(Gd,Ca)₃(Ga,Mg,Zr)₅0₁₂ eines Durchmessers von 30 mm verwendet, die vor dem Abscheidungsprozeß auf bekannte Weise gereinigt und angeätzt wurden.

Für die Herstellung von Targets wurden Pulvergemische aus BiFe0₃, BiGd₂Fe₅0₁₂, Al₂0₃ und Ga₂0₃ in Sauerstoffatmosphäre eines Drucks von 100 Pa über eine Dauer von 6 h bei einer Temperatur kleiner als 920 ^{o}C gesintert, wobei der Prozeß so geführt wird, daß kaum freies Bi₂0₃ im Keramikgefüge zurückbleibt. Freies Bi₂O₃ soll deswegen nicht im Target vorhanden sein, weil es zur mechanischen Desintegration der Oberfläche des Targets durch seine gegenüber den anderen Targetbestandteilen erhöhte Zerstäubungsrate führt; durch die Verwendung von Mischoxiden wird eine Homogenisierung der Zerstäubungsrate aller Phasenbestandteile des Targets erreicht.

Zur Herstellung einer etwa 2 µm dicken polykristallinen Eisengranatschicht der Zusammensetzung
Gd₂,₁₁Bi₁,₀₁Fe₄,₀₆Ga₀,₈₂0₁₂ und einer etwa 5 nm dicken amorphen oder röntgenamorphen Eisengranatschicht der Zusammensetzung
Gd₂,₁₈Bi₀,₃₆Fe₄,₃₁Ga₁,₁₅0₁₂ wurde ein Target folgender Zusammensetzung verwendet

| (Angaben in Gew.%): | |
|---|---|
| Gd₂O₃ | 34,44 |
| Bi₂O₃ | 28,52 |
| Fe₂O₃ | 30,91 |
| Ga₂O₃ | 6,13 |

Der Targetkörper wird auf der Targetelektrode mit einem gut wärmeleitenden Kleber (z.B. mit Silberpulver gefülltes Epoxydharz) befestigt.

Um Verlustwärme abzuführen, ist es zweckmäßig, z.B. durch Wasser, gekühlte Targetelektroden einzusetzen.

Der Abscheidungsprozeß wird so geführt, daß die Zerstäubungsapparatur zunächst mit einer Vakuumpumpe bis zu einem Druck kleiner als 10 ⁻³ Pa evakuiert wird, anschließend wird ein Edelgas, vorzugsweise Argon, eines Drucks von 0,6 Pa eingeleitet.Der Abstand zwischen Substrat und Target beträgt 80 mm. Die Niederschlagsrate liegt bei etwa 1,0 µm/h.

Zur Abscheidung der etwa 5 nm dicken röntgenamorphen Zwischenschicht aus Eisengranat wird die Substrattemperatur auf etwa 460 ^{o}C eingestellt. Die an der HF-Zuleitung an der Targetelektrode gemessene HF-Spannung beträgt 200 V_{eff}. Zum Abscheiden der polykristallinen Eisengranatschicht auf der röntgenamorphen Eisengranatschicht (Zwischenschicht) wird das Substrat zunächst auf eine Temperatur größer als 520 ^{o}C aufgeheizt. Dann wird an der Substratelektrode über eine einstellbare HF-Impedanz in der Zuleitung eine HF-Spannung von 50 V_{eff} eingestellt, die linear auf 0 verringert wird innerhalb der ersten 30 s des Abscheidens der anschließend auf der röntgenamorphen Eisengranatschicht abzuscheidenden polykristallinen Eisengranatschicht; nach Verringern der HF-Spannung auf 0 stellt sich ein schwebendes elektrisches Potential an der Substratelektrode ein, wenn außerdem die Substratelektrode von der HF-Zuleitung und dem Impedanznetzwerk getrennt wird.

Nach diesem Verfahren werden polykristalline Eisengranatschichten mit relativ glatter Oberfläche erhalten, die gemäß Untersuchungen im Transmissionselektronenmikroskop eine einheitliche Morphologie zeigten, die der von einkristallinen Eisengranatschichten nahekommt. Die mittels des vorliegenden Verfahrens hergestellten polykristallinen Eisengranatschichten wiesen eine relativ glatte magnetische Domänenstruktur mit gegenüber polykristallinen Schichten, die ohne regelbare HF-Spannung an der Substratelektrode hergestellt wurden, deutlich verringerter Koerzitivfeldstärke. Die nach dem vorliegenden Verfahren hergestellten polykristallinen Eisengranatschichten wiesen eine ausgeprägte (111)-Textur auf.

Es ist hervorzuheben, daß die Mikrostruktur des für die Abscheidung der Schichtenfolge aus einer amorphen (oder röntgenamorphen) Eisengranatschicht und einer polykristallinen Eisengranatschicht eingesetzten Substrates, also z.B. eine (111)-orientierte nicht-magnetische Granat-Einkristallscheibe, für die Morphologie der hergestellten polykristallinen Schichten nicht von Einfluß ist, da die polykristalline Eisengranatschicht auf der auf dem Substrat zunächst abgeschiedenen röntgenamorphen oder amorphen Eisengranatschicht abgeschieden wird. Andererseits wird die für die Kristallkeimbildung der polykristallinen Schicht wichtige Oberflächenenergie durch die Grenzfläche mit der amorphen (oder röntgenamorphen) Eisengranatschicht vorgegeben. Hieraus resultiert, daß mit dem vorliegenden Verfahren relativ beliebige Substrate mit einer polykristallinen Eisengranatschicht mit relativ geringer Oberflächenrauhigkeit beschichtet werden können, wenn nur eine Zwischenschicht aus röntgenamorphem Eisengranat vorhanden ist. Bei der Auswahl der Substrate spielt neben der Art des herzustellenden Bauelementes im wesentlichen nur die chemische und thermische Beständigkeit sowie der Wärmeausdehnungskoeffizient des Substratmaterials eine Rolle.

## Patentansprüche

1. Verfahren zur Herstellung von Eisengranatschichten in einer Schichtenfolge unterschiedlicher Ordnung mittels HF-Kathodenzerstäubung unter Verwendung eines überwiegend eine Eisengranatphase neben Restphasen nahezu gleicher Zerstäubungsrate enthaltenden Targets in einem Edelgasplasma einer Ionenergie der die anwachsende Schicht bombardierenden Ionen kleiner als 10² eV und eines Drucks im Bereich von 0,1 bis 2,0 Pa auf einem Substrat,
dadurch gekennzeichnet,
daß unter Einspeisung von HF-Leistung mit einer HF-Spannung von etwa 200 V_{eff} in die Targetelektrode (Kathode) bei einer Substrattemperatur kleiner als 460 ^{o}C zunächst eine amorphe bis röntgenamorphe Eisengranatschicht als Zwischenschicht und danach bei einer Substrattemperatur größer als 520 ^{o}C eine polykristalline Eisengranatschicht abgeschieden wird unter gleichzeitigem Anlegen einer HF-Spannung an die Substratelektrode von etwa 50 V_{eff}, die linear während der Abscheidung der ersten 5-10 nm Schichtdicke auf ein gegenüber Masse schwebendes Potential zurückgeführt wird.

2. Verfahren nach Anspruch 1,
dadurch gekennzeichnet,
daß die amorphe bis röntgenamorphe Zwischenschicht in einer Dicke von bis zu 5 nm abgeschieden wird.

3. Verfahren nach den Ansprüchen 1 und 2,
dadurch gekennzeichnet,
daß als Edelgas Argon eingesetzt wird.

4. Verfahren nach mindestens einem der Ansprüche 1 bis 3, daß der Druck der Edelgasatmosphäre auf einen Wert im Bereich von 0,3 bis 1,0 Pa eingestellt wird.

5. Verfahren nach Anspruch 4,
dadurch gekennzeichnet,
daß der Druck auf einen Wert von 0,6 Pa eingestellt wird.

6. Verfahren nach mindestens einem der Ansprüche 1 bis 5,
dadurch gekennzeichnet,
daß die Eisengranatschichten eine Zusammensetzung gemäß der allgemeinen Formel (A,B)₃(A,B)₅0₁₂ haben mit
A = mindestens ein Seltenerdmetall, Bi,Pb und/oder Ca und
B = Ga, Al, Fe, Co, Ni, Mn, Ru, Ir, In und/oder Sc.

7. Verfahren nach Anspruch 6,
dadurch gekennzeichnet,
daß die polykristalline Eisengranatschicht eine Zusammensetzung hat gemäß der Formel
Gd₂,₁₁Bi₁,₀₁Fe₄,₀₆Ga₀,₈₂0₁₂.

8. Verfahren nach Anspruch 6,
dadurch gekennzeichnet,
daß die amorphe bis röntgenamorphe Eisengranatschicht eine Zusammensetzung hat gemäß der Formel
Gd₂,₁₈Bi₀,₃₆Fe₄,₃₁Ga₁,₁₅0₁₂.

9. Verfahren nach mindestens einem der Ansprüche 1 bis 8,
dadurch gekennzeichnet,
daß ein Substrat einkristalliner Ordnung eingesetzt wird.

10. Verfahren nach Anspruch 9,
dadurch gekennzeichnet,
daß als Substrat eine einkristalline Scheibe aus Halbleitermaterial eingesetzt wird.

11. Verfahren nach Anspruch 10,
dadurch gekennzeichnet,
daß ein Substrat aus einer A^{III}B^{V}-Verbindung eingesetzt wird.

12. Verfahren nach Anspruch 11,
dadurch gekennzeichnet,
daß ein Substrat aus Galliumarsenid eingesetzt wird.

13. Verfahren nach Anspruch 11,
dadurch gekennzeichnet,
daß ein Substrat aus Indiumphosphid eingesetzt wird.

14. Verfahren nach mindestens einem der Ansprüche 1 bis 8,
dadurch gekennzeichnet,
daß ein Substrat nicht-einkristalliner Ordnung eingesetzt wird.

15. Verfahren nach Anspruch 10 oder 14,
dadurch gekennzeichnet,
daß ein Substrat aus Silicium eingesetzt wird.

16. Verfahren nach Anspruch 14,
dadurch gekennzeichnet,
daß ein Glassubstrat eingesetzt wird.

17. Verfahren nach mindestens einem der Ansprüche 1 bis 16,
dadurch gekennzeichnet,
daß als Targetelektrode ein Magnetron, in das die für den Zerstäubungsprozeß erforderliche HF-Leistung eingespeist wird, eingesetzt wird.

## Claims

1. A method of manufacturing iron garnet layers on a substrate, in a layer sequence of different order by means of RF-cathode sputtering in an inert gas plasma, making use of a target which comprises predominantly an iron garnet phase in addition to residual phases having an almost equal sputtering rate, the ions of said inert gas plasma bombarding the growing layer having an ion energy of less than 10² eV and the pressure of said inert gas plasma ranging from 0.1 to 2.0 Pa, characterized in that RF-power is applied to the target electrode (cathode) at an RF-voltage of approximately 200 Vᵣₘₛ, thereby first depositing an amorphous to X-ray amorphous iron garnet layer as an intermediate layer at a substrate temperature below 460°C and, subsequently, a polycrystalline iron garnet layer at a substrate temperature exceeding 520°C, while simultaneously applying an RF-voltage of approximately 50 Vᵣₘₛ to the substrate electrode, which voltage is linearly reduced during the deposition of the first 5-10 nm of the layer to a floating potential relative to earth.

2. A method as claimed in Claim 1, characterized in that the amorphous to X-ray amorphous intermediate layer is deposited in a thickness up to 5 nm.

3. A method as claimed in Claims 1 and 2, characterized in that argon is used as the inert gas.

4. A method as claimed in at least one of the Claims 1 up to and including 3, characterized in that the pressure of the inert gas atmosphere is adjusted at a value in the range from 0.3 to 1.0 Pa.

5. A method as claimed in Claim 4, characterized in that the pressure is adjusted at a value of 0.6 Pa.

6. A method as claimed in at least one of the Claims 1 up to and including 5, characterized in that the iron garnet layers have a composition in accordance with the general formula
(A, B)₃(A, B)₅O₁₂ wherein
A = at least one rare earth metal, Bi, Pb and/or Ca, and
B=Ga, Al, Fe, Co, Ni, Mn, Ru, Ir, In and/or Sc.

7. A method as claimed in Claim 6, characterized in that the polycrystalline iron garnet layer has a composition in accordance with the formula
Gd₂,₁₁Bi₁,₀₁Fe₄,₀₆Ga₀,₈₂O₁₂.

8. A method as claimed in Claim 6, characterized in that the amorphous to X-ray amorphous iron garnet layer has a composition in accordance with the formula
Gd₂,₁₈Bi₀,₃₆Fe₄,₃₁Ga₁,₁₅O₁₂.

9. A method as claimed in at least one of the Claims 1 up to and including 8, characterized in that a substrate having a monocrystalline order is used.

10. A method as claimed in Claim 9, characterized in that a monocrystalline disc of a semiconductor material is used as the substrate.

11. A method as claimed in Claim 10, characterized in that a substrate of a III-V-compound is used.

12. A method as claimed in Claim 11, characterized in that a substrate of gallium arsenide is used.

13. A method as claimed in Claim 11, characterized in that a substrate of indium phosphide is used.

14. A method as claimed in at least one of the Claims 1 up to and including 8, characterized in that a substrate having a non-monocrystalline order is used.

15. A method as claimed in Claim 10 or 14, characterized in that a substrate of silicon is used.

16. A method as claimed in Claim 14, characterized in that a glass substrate is used.

17. A method as claimed in at least one of the Claims 1 up to and including 16, characterized in that a magnetron is used as the target electrode, into which the RF-power required for the sputtering process is fed.

## Revendications

1. Procédé de fabrication de couches de grenat de fer sur un substrat, dans une séquence de couches d'ordre différent, par pulvérisation cathodique HF, utilisant une cible comportant principalement une phase de grenat de fer, en plus de phases résiduaires présentant une vitesse de pulvérisation pratiquement égale, dans un plasma de gaz inerte ayant une énergie ionique dont les ions bombardant la couche croissante est inférieure à 10² eV et dont la pression exercée sur un substrat est située dans la gamme comprise entre 0,1 et 2,0 Pa, caractérisé en ce que d'abord, à une température de substrat inférieure à 460°, comme couche intermédiaire, est déposée une couche de grenat de fer amorphe jusqu'à radiologiquement amorphe en appliquant à l'électrode de cible (cathode) une puissance HF ayant une tension HF de l'ordre de 200 V_{eff}, et que, ensuite, à une température de substrat supérieure à 520°C, est déposée une couche de grenat de fer polycristalline, en appliquant simultanément à l'électrode de substrat une tension HF de l'ordre de 50 V_{eff} qui lors du dépôt de la première couche dont l'épaisseur est comprise entre 5 et 10 nanomètres est réduite linéairement à un potentiel flottant par rapport à la masse.

2. Procédé selon la revendication 1, caractérisé en ce que l'épaisseur de dépôt totale de la couche amorphe ou radiologiquement amorphe est de l'ordre de 5 nm.

3. Procédé selon les revendications 1 et 2, caractérisé en ce qu'on utilise de l'argon comme gaz rare.

4. Procédé selon au moins l'une quelconque des revendications 1 à 3, caractérisé en ce que la pression de l'atmosphère de gaz rare est ajustée sur une valeur située dans la gamme comprise entre 0,3 et 1,0 Pa.

5. Procédé selon la revendication 4, caractérisé en ce que la pression est ajustée sur une valeur de 0,6 Pa.

6. Procédé selon l'une quelconque des revendications 1 à 5, caractérisé en ce que les couches de grenat de fer présentent une composition répondant à la formule générale (A, B)₃(A, B)₅O₁₂ où
A = au moins un métal de terre rare, Bi, Pb et/ou Ca et
B = Ga, Al, Fe, Co, Ni, Mn, Ru, Ir, In et/ou Sc.

7. Procédé selon la revendication 6, caractérisé en ce que la couche de grenat de fer polycristalline présente une composition selon la formule
Gd_{2,11}Bi_{1,01}Fe_{4,06}Ga_{0,82}O₁₂.

8. Procédé selon la revendication 6, caractérisé en ce que la couche de grenat de fer amorphe jusqu'à radiologiquement amorphe présente une composition selon la formule Gd_{2,18}Bi_{0,36}Fe_{4,31}Ga_{1,15}O₁₂.

9. Procédé selon au moins l'une quelconque des revendications 1 à 8, caractérisé en ce que l'on utilise un substrat d'ordre monocristallin.

10. Procédé selon la revendication 9, caractérisé en ce que l'on utilise un disque monocristallin en matériau semiconducteur.

11. Procédé selon la revendication 10, caractérisé en ce que l'on utilise un substrat réalisé à partir d'un composé A^{III}B^{V}.

12. Procédé selon la revendication 11, caractérisé en ce que l'on utilise un substrat en arséniure de gallium.

13. Procédé selon la revendication 11, caractérisé en ce que l'on utilise un substrat en phosphure d'indium.

14. Procédé selon au moins l'une quelconque des revendications 1 à 8, caractérisé en ce que l'on utilise un substrat d'ordre non-monocristallin.

15. Procédé selon la revendication 10 ou 14, caractérisé en ce que l'on utilise un substrat en silicium.

16. Procédé selon la revendication 14, caractérisé en ce que l'on utilise un substrat en verre.

17. Procédé selon au moins l'une quelconque des revendications 1 à 16, caractérisé en ce que l'on utilise comme électrode de cible un magnétron qui est alimenté de la puissance HF indispensable pour le procédé de pulvérisation.
